# EUROPEAN PATENT APPLICATION

(11) **EP 4 239 260 A1**
(43) Date of publication of application: **06.09.2023**
(21) Application number: 20962834.6
(22) Date of filing: 26.11.2020
(51) Int. Cl.: F24S 23/74, H02S 40/22

(54) **SOLAR ENERGY UTILISATION APPARATUS**

(71) Applicant: Bolymedia Holdings Co. Ltd., Santa Clara, California 95051 (US)
(72) Inventor: HU, Xiaoping, Shenzhen, Guangdong 518109 (CN)
(74) Representative: Manitz Finsterwald Patent- und Rechtsanwaltspartnerschaft mbB
(86) International application number: PCT/CN2020/131862
(87) International publication number: WO 2022/109943

(57) **Abstract**

A solar energy utilization device (1000), solar light emitted from a transparent liquid (200) to a light receiver (120) in the apparatus (1000) forming total reflection; in addition, a light energy utilization portion (310) is laid above the bottom wall (112) of a light concentrating tank (110), better facilitating the concentration of solar light on the light energy utilization portion (310) by a liquid light concentrating apparatus (100), thereby preventing the solar light from being refracted from the light receiver (120) after being reflected by the light concentrating tank (110) into the transparent liquid (200), concentrating more solar light on the light energy utilization portion (310) of the light energy utilization apparatus (300), and increasing the light concentrating efficiency.

## Description

### TECHNICAL FIELD

The present disclosure relates to light energy conversion utilization devices.

### BACKGROUND

Solar energy systems are increasingly used with the reduction of the cost of photovoltaic panels and the increase of efficiency. However, as solar energy systems become more widely used, problems arise, such as increased land costs, the cost of plant maintenance (including cleaning of dust and sweeping of ice and snow), and difficulty in recycling photovoltaic panels.

### SUMMARY

The present disclosure mainly provides a new type of solar energy utilization device to demonstrate a new solar energy utilization structure.

Based on the above object, a solar energy utilization device is provided in an embodiment of the present disclosure, comprising:
a light energy utilization unit having a light energy utilization portion capable of receiving, converting and utilizing solar light; and
at least one liquid condensing unit having a closed cavity, a light concentrating tank, and a light receiver for transmitting the solar light into the light concentrating tank, wherein the light receiver and the light concentrating tank form part or all walls of the closed cavity, the closed cavity is filled with a transparent liquid, an inner wall of the light concentrating tank is provided with a reflective surface for reflecting the solar light, the light energy utilization portion is laid above a bottom wall of the light concentrating tank, the transparent liquid is contact with the light receiver, the solar light in the liquid condensing unit transmitted from the transparent liquid to the light receiver forms total reflection so as to concentrate the solar light onto the light energy utilization portion.

In an embodiment, the light energy utilization unit is arranged at an outside the light receiver, the light energy utilization portion is attached onto the light receiver so as to concentrate the solar light in the light concentrating tank to the light energy utilization portion.

In an embodiment, the light energy utilization portion is arranged in the closed cavity, or the light energy utilization portion forms part wall of the closed cavity.

In an embodiment, a structure is arranged between the light concentrating tank and the light receiver such that the solar light, after being reflected by the reflective surface, is transmitted from the transparent liquid to the light receiver to form the total reflection.

In an embodiment, at least part of the reflective surface of the light concentrating tank form an acute angle with the light receiver, the acute angle being less than or equal to 40 degrees.

In an embodiment, the transparent liquid fully fills the closed cavity.

In an embodiment, the liquid condensing unit is provided with a raised A shaped reflector or a reflective Fresnel lens, and the light energy utilization portion is arranged above the A shaped reflector or the reflective Fresnel lens.

In an embodiment, the liquid condensing unit is provided with a gas container made of transparent material, the gas container is arranged on the A shaped reflector or the reflective Fresnel lens, the light energy utilization portion is arranged above the gas container, and the gas container is configured to make at least part of the solar light transmitted from the transparent liquid to form the total reflection so as to concentrate the solar light toward the light energy utilization portion.

In an embodiment, the liquid condensing unit is provided with at least a light guide element arranged in the closed cavity for guiding the solar light to the light energy utilization portion by means of reflection or refraction.

In an embodiment, the device may also comprises a closed container, wherein the liquid condensing unit is arranged in the closed container to separate a second closed cavity from the closed container, the second closed cavity is filled with a vacuum or with air, water or the same transparent liquid as in the closed cavity.

In an embodiment, the second closed cavity is sealed off from the closed cavity of the liquid condensing unit.

In an embodiment, the wall of the second closed cavity is provided with an opening to communicate the second closed cavity with outside.

In an embodiment, the bottom wall of the light concentrating tank is a reflector in a A shape protrusion.

In an embodiment, the liquid condensing unit further comprises a brim obliquely extended from the light receiver to two sides, the brim being configured to lap with the adjacent liquid condensing unit.

In an embodiment, one side of the light energy utilization unit is provided with the light energy utilization portion, or both sides of the light energy utilization unit are provided with the light energy utilization portion.

In accordance with the solar energy utilization device mentioned in above embodiments, the light energy utilization unit and the at least a liquid condensing unit are included. The liquid condensing unit is filled with the transparent liquid. The liquid condensing unit has at least one of the light receiver that can transmit the solar light to the transparent liquid and the light concentrating tank that can reflect the incident solar light. The solar light in the liquid condensing unit transmitted from the transparent liquid to the light receiver can form total reflection. The light energy utilization portion laid above the bottom wall of the light concentrating tank can better facilitate the concentration of the solar light on the light energy utilization portion by the liquid condensing unit, thereby preventing the solar light from being refracted from the light receiver after being reflected by the light concentrating tank into the transparent liquid, concentrating more solar light on the light energy utilization portion of the light energy utilization unit to improve concentrating efficiency.

### BRIEF DESCRIPTION OF THE DRAWINGS

FIG. 1 is a schematically cross-sectional diagram of the solar energy utilization device in Example 1 according to the present disclosure;
FIG. 2 is a schematically cross-sectional diagram of the solar energy utilization device in Example 2 according to the present disclosure;
FIG. 3 is a schematically cross-sectional diagram of the solar energy utilization device in Example 3 according to the present disclosure; and
FIG. 4 is a schematically cross-sectional diagram of the solar energy utilization device in Example 4 according to the present disclosure.

### Detailed Description

The present disclosure will be further described in detail below through specific embodiments with reference to the accompanying drawings. Common or similar elements are referenced with like or identical reference numerals in different embodiments. Many details described in the following embodiments are for better understanding the present disclosure. However, those skilled in the art can realize with minimal effort that some of these features can be omitted in different cases or be replaced by other elements, materials and methods. For clarity some operations related to the present disclosure are not shown or illustrated herein so as to prevent the core from being overwhelmed by excessive descriptions. For those skilled in the art, such operations are not necessary to be explained in detail, and they can fully understand the related operations according to the description in the specification and the general technical knowledge in the art.

In addition, the features, operations or characteristics described in the specification may be combined in any suitable manner to form various embodiments. At the same time, the steps or actions in the described method can also be sequentially changed or adjusted in a manner that can be apparent to those skilled in the art. Therefore, the various sequences in the specification and the drawings are only for the purpose of describing a particular embodiment, and are not intended to be an order of necessity, unless otherwise stated one of the sequences must be followed.

The serial numbers of components herein, such as "first", "second", etc., are only used to distinguish the described objects and do not have any order or technical meaning. The terms "connected", "coupled" and the like here include direct and indirect connections (coupling) unless otherwise specified.

A solar energy utilization device provided in an embodiment of the present disclosure can be configured for receiving and utilizing solar light for energy conversion, converting the solar light into electrical, thermal and other forms of energy for use.

The solar energy utilization device in the embodiment may include a light energy utilization unit and at least a liquid condensing unit.

The light energy utilization unit may have a light energy utilization portion capable of receiving, converting and utilizing the solar light. In an embodiment, the light energy utilization portion may be one or more of a photovoltaic panel, a photo-thermal utilization unit, a combined photovoltaic and thermal utilization unit, a concentrating light energy utilization unit. The photovoltaic panel may generally refer to any component that can directly convert light energy into electrical energy, including various semiconductor photovoltaic panels, photovoltaic films, quantum dot photovoltaic conversion components, and the like. In other embodiments, the light energy utilization portion may also be another form of solar light utilization converting structure.

The liquid condensing unit may have a closed cavity, a light concentrating tank, and a light receiver for transmitting the solar light into the light concentrating tank. The light receiver may be made of transparent material and form part or all walls of the closed cavity together with the light concentrating tank. That is, the closed cavity may be directly enclosed by the light receiver and the light concentrating tank, or it may enclosed by the light receiver, the light concentrating tank and other components. The closed cavity is filled with transparent liquid which is in contact with the light receiver. The inner wall of the light concentrating tank may have a reflective surface for reflecting the solar light. The light energy utilization portion may be laid above the bottom wall of the light concentrating tank.

The solar energy utilization device may be typically arranged with the light receiving surface of the light receiver facing the sun, so that the solar light can be cast into the transparent liquid within the liquid condensing unit from the light receiving surface. The solar light incident into the transparent liquid may pass through the transparent liquid, and part of the solar light may enter the reflector and be reflected by the light concentrating tank into the transparent liquid. The structure of the liquid condensing unit may be configured as: making the solar light be transmitted to the light receiver from the transparent liquid to form total reflection (or total internal reflection); that is, the solar light reflected into the transparent liquid will not or most of it will not exit from the light receiving surface, instead, it will continue to propagate in the liquid condensing unit under the effect of total reflection and finally concentrate onto the light energy utilization portion. In the present disclosure, the light totally reflected mainly comes from the light reflected by the light concentrating tank, however, it may be totally reflected and reused in the whole traveling light path within the liquid condensing unit.

In this embodiment, by employing the transparent liquid as a light propagation medium, and using the contact between the transparent liquid and the light receiver and the difference in refractive index between the light receiver and external air to form the total reflection phenomenon, the sunlight transmitted through the light receiving surface can be avoided from being reflected by the light concentrating tank into the transparent liquid before being refracted out from the light receiver, so that more sunlight can be concentrated onto the light energy utilization portion of the light energy utilization unit, thereby improving the concentration efficiency. The light receiver in this embodiment functions as both light transmission and total reflection. Compared with the prior art, under the same conditions of the light receiver, the liquid condensing unit can converge more sunlight onto the light energy utilization portion, increasing the concentration ratio.

In this embodiment, the light energy utilization portion is laid above the bottom wall of the light concentrating tank, better facilitating the concentration of the solar light on the light energy utilization portion by the liquid condensing unit.

In addition, the transparent liquid may also directly or indirectly form a heat transfer structure with the light energy utilization portion, which may further play a role in cooling or absorbing heat to the light energy utilization portion, so as to improve the rate of light energy utilization.

Further, in the process of forming the total reflection phenomenon described above, there is a structure between the light concentrating tank and the light receiver that enables the sunlight transmitted from the transparent liquid toward the light receiver to form the total reflection. For example, the aforesaid total reflection phenomenon may be achieved by designing the shapes and structures of the reflector and the light receiver and the angle therebetween.

In implementation of the total reflection, the light concentrating tank may form a very small acute angle with the light receiver; for example, in an embodiment, at least a part of the reflective surface of the light concentrating tank may form an acute angle less than or equal to 40 degrees with the light receiving surface of the light receiver, thereby reducing the overall height of the liquid condensing unit, making it more environmentally adaptable and applicable. The reflective surface of the light concentrating tank may refer to a side of the light concentrating tank that is used to reflect the solar light incident from the transparent liquid. The light receiving surface of the light receiver may refer to a side where the solar light enters the light receiver. Such structure can lower the height of the liquid condensing unit, making it more adaptable to the environment and more applications. This is difficult to do with existing concentrating tanks, which fail to take advantage of the light receiver's total reflection capability when filled with the transparent liquid.

In some embodiments, the liquid condensing unit may also be used to cool the light energy utilization unit at the same time so as to improve the utilization efficiency of light energy.

The liquid condensing unit may condense all or most of the incident solar light on to the light energy utilization unit. In order to receive the solar light, the light energy utilization unit may be arrange at the outside of the light receiver, and the light energy utilization portion may be attached onto the light receiver so that the solar light in the light concentrating tank can be concentrated to the light energy utilization portion. Alternatively, the light energy utilization portion is directly arranged in the closed cavity; or the light energy utilization portion may form part of the wall of the closed cavity.

Specifically, in one embodiment, the light receiver is made of a light transmitting material, and the light energy utilization portion is attached to the outside of the condenser. For example, the light energy utilization portion is fixedly attached to the outside of the light receiver. In the liquid condensing unit, the solar light may converge towards the light energy utilization portion to enter into the light energy utilization portion.

In another embodiment, the light energy utilization unit may be immersed directly in the transparent liquid and may directly receive the solar light transmitted from the transparent liquid.

In yet another embodiment, the light energy utilization portion may serve as part of the liquid condensing unit, and the outer wall of the light energy utilization portion (a side surface used for receiving the solar light) and the light concentrating tank together with the light receiver may enclose the closed cavity.

In an embodiment, the light concentrating tank may function primarily to reflect the solar light, which may be in a groove shape to meet the requirements for reflecting the solar light. All or part of the inner walls of the light concentrating tank may be a reflective surface to reflect the solar light. The inner walls of the light concentrating tank may be formed by a planar surface, a folded surface, a curve surface or a combination thereof.

When the liquid condensing unit is utilized, one or more liquid condensing units may be used for concentration. Accordingly, the light energy utilization unit may have one or more light energy utilization portions, or may be provided with one or more light energy utilization units to be used in combination with the liquid condensing unit. Alternatively, the light energy utilization unit may be a light energy utilization unit with a built-in condenser. For example, a single side of the light energy utilization unit is provided with the light energy utilization portion, or both sides of the light energy utilization unit is provided with the light energy utilization portion.

In an embodiment, the transparent liquid may be purified water (water), an antifreeze liquid (a mixture of water and glycol), or another environmentally friendly clear liquid (such as a mixture of water and glycerin).

Based on the above inventive concept, several different embodiments are further described below to better illustrate the inventive concept.

### Example 1:

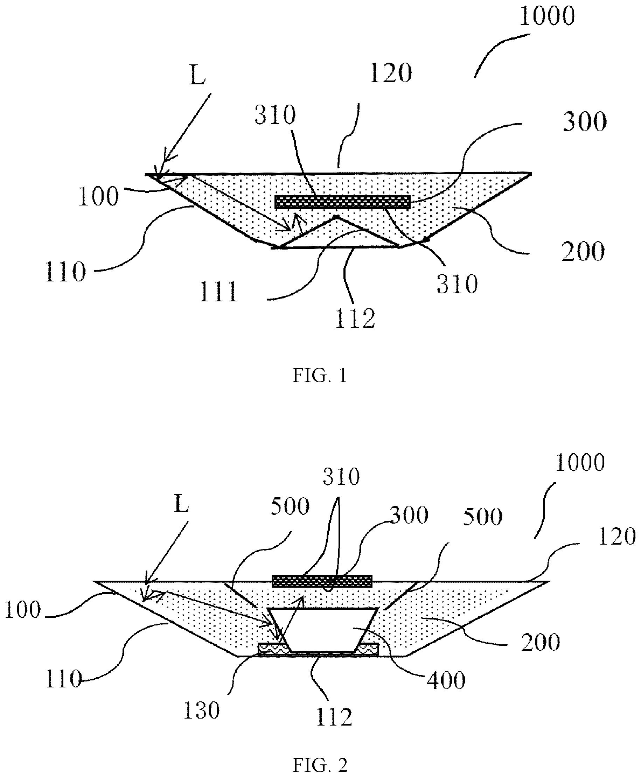

Referring to FIG.1, the solar energy utilization device 1000 may include a liquid condensing unit 100 and a light energy utilization unit 300. The liquid condensing unit 100 may include a light concentrating tank 110 and a light receiver 120. The light concentrating tank 110 may be open at the upper thereof, and the light receiver 120 may be a transparent top cover. Of course, the light concentrating tank 110 may also be open at a side or another portion thereof in other embodiments.

In the liquid condensing unit 100 shown in this example, the light concentrating tank 110 and the light receiver 120 (other components may also be combined thereto) may enclose a closed cavity. In other embodiments, the closed structure may be arranged within another closed cavity (a closed container as shown below), or share a part of the surface with another closed container. Even, a plurality of different closed cavities (e.g. separated left and right) may be arranged, or the closed structure may be divided into several pieces arranged in the different closed cavities respectively.

The liquid condensing unit 100 may be filled with transparent liquid 200. It is better that the transparent liquid 200 may basically fill the entire closed cavity for the best effect. The light energy utilization unit 300 may be immersed in the transparent liquid 200. The light energy utilization unit 300 may have gaps above and below, so it may be provided with light energy utilization portions 310 on upper and lower sides.

FIG. 1 shows the process in which incident light (L) may, after reflected back the light receiver 120 by the light concentrating tank 110, be totally reflected by the light receiver 120 to finally reach the double-sided light energy utilization unit 300. The structure shown in this example can make full use of the total reflection function of the transparent liquid 200 in the liquid condensing unit 100 to increase a concentration ratio, lower the height of the light condensing unit, and improve efficiency for solar energy utilization by cooling the double-sided light energy utilization unit 300. That is, the light receiver 120 has two functions at the same time: transmitting externally incident light, and totally reflecting the reflected light from the light concentrating tank 110.

Since the principle of total reflection utilized in the present disclosure, the angle between the light concentrating tank 110 and the light receiver 120 in this example may be an acute angle less than 40 degrees, which is difficult to achieve by existing concentrating tanks.

The light concentrating tank 110 may consist of multiple folding surfaces in this example, or curved surfaces in other examples. The reflective surface of the light concentrating tank 110 may be pure mirror. Alternatively, all or part of the reflective surface may be a reflective Fresnel lens face. The Fresnel lens may also be formed by using the transparent liquid, greatly reducing costs.

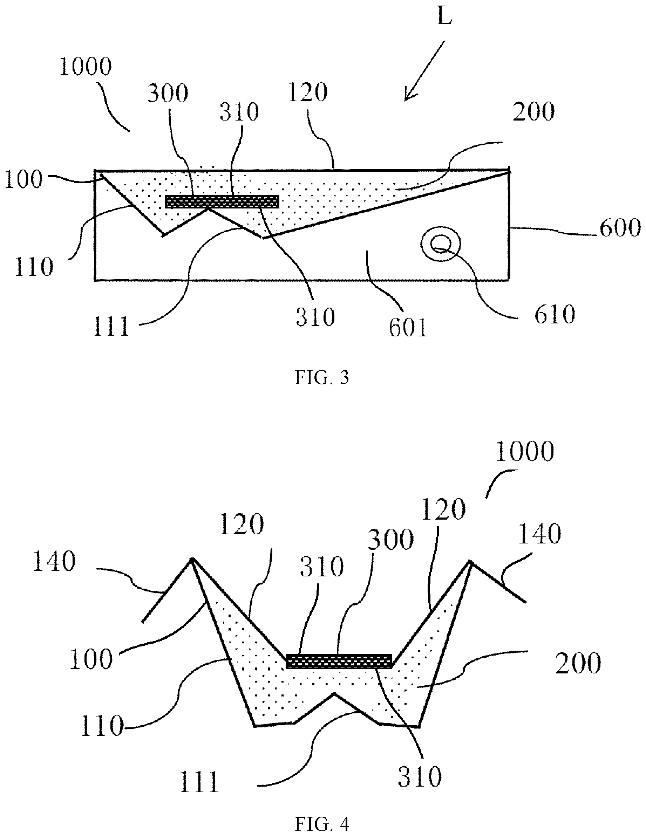

In this example, the light energy utilization portion 310 may be laid above the bottom wall 112 of the light concentrating tank 110. One side of the light energy utilization portion 310 may face toward the bottom wall 112 of the light concentrating tank 110. The light concentrating tank may be provided with a raised A shaped reflector 111 at the bottom. The A shaped reflector 111 used as another component may be arranged separately in the light concentrating tank 110. As shown in FIG. 1, a flat bottom wall 112 may be arranged under the A shaped reflector 111. This bottom wall 112 may be unnecessary, but may lead to simplification of manufacturing or cost reduction. In another example, the A shaped reflector 111 may directly be the bottom wall of the light concentrating tank 110, as shown in FIG. 3 and FIG. 4.

Further, in this example, the liquid condensing unit 100 is in a symmetric structure; and the light energy utilization unit 300 is arranged in the center of the liquid condensing unit 100. In other examples, the liquid condensing unit 100 may be asymmetric; and the light energy utilization unit 300 may be arranged in the center or other locations of the liquid condensing unit 100.

### Example 2:

Referring to FIG. 2, this Example 2 provides another solar energy utilization device 1000.

In the embodiment, the solar energy utilization device 1000 may include a liquid condensing unit 100 and a light energy utilization unit 300. The liquid condensing unit 100 may include a light concentrating tank 110 and a light receiver 120. In this embodiment, the liquid condensing unit 100 may be provided with a reflective Fresnel lens (which may also be replaced by the A shaped reflector 111 or a reflective structure in other shape and type). The reflective Fresnel lens 130 may be arranged on the bottom wall 112 of the light concentrating tank 110. Of course, the reflective Fresnel lens 130 may be integrated with the bottom wall 112 of the light concentrating tank 110, or it may be a separate arrangement. The light energy utilization portion may be arranged above the A shaped reflector 111 or the reflective Fresnel lens 130.

In the example as shown in FIG. 2, the light energy utilization unit 300 and the light receiver 120 are integrated as a whole. For example, the light energy utilization unit 300 (or the light energy utilization portion 310) may be served as a part of the wall of the closed cavity of the liquid condensing unit 100. Of course, the light energy utilization unit 300 may also be directly immersed in the transparent liquid 200 as shown in FIG. 1.

Further, the liquid condensing unit 100 may also be provided with a gas container 400 made of transparent material. The gas container 400 may for example an air bag. The gas container 400 may be arranged on the A shaped reflector 111 (as shown in FIG. 1) or the reflective Fresnel lens 130. The light energy utilization portion 310 may be arranged above the gas container 400. The gas container 400 may be used to make at least part of the solar light transmitted from the transparent liquid 200 to form total reflection so as to concentrate the solar light toward the light energy utilization portion 310. The solar light that fails to involve in the total reflection may also be transmitted directly from the gas container 400 onto the light energy utilization unit 300.

Again, the gas container 400 uses the principle of total reflection to deflect light from certain directions in a favorable direction. The gas container 400 and the A shaped reflector 111 or the reflective Fresnel lens 130 at the bottom of the light concentrating tank 110 may be used together such that a portion of the gas container 400 that contains gas may be arranged above the A shaped reflector 111 or the reflective Fresnel lens 130.

In an embodiment, the gas container 400 may be wedge-shaped, such as a pointed wedge, or a cone-shaped as shown in FIG. 2. Since FIG. 2 is a cross-section diagram, the wedge shape in the embodiment may represent a strip cone and the cone shape may represent a strip ladder in the three-dimensional structure.

Further, to improve the condensing effect, the liquid condensing unit 100 may be provided with at least a light guide element 500 in an example. The light guide element 500 may be arranged in the closed cavity and guide the solar light to the light energy utilization portion 310 by reflection or refraction.

Specifically, in an embodiment, referring to FIG. 2, the arrangement may increase a theoretical concentration ratio (i.e. the ratio of light receiving area of the light receiver 120 to PV panel area) by introducing two light guide elements 500.

In an embodiment, the light guide element 500 may be a double-sided reflecting and guiding panel which may guide the solar light directly or indirectly to the light energy utilization portion 310 by reflection. The two light guide elements may be obliquely arranged on both sides of the light energy utilization unit 300 so as to better guide the solar light to the light energy utilization unit 300.

### Example 3:

Referring to FIG. 3, yet another solar energy utilization device 1000 is provided in this Example 3.

In the example, the solar energy utilization device 1000 may include a liquid condensing unit 100 and a light energy utilization unit 300. The liquid condensing unit 100 may include a light concentrating tank 110 and a light receiver 120. Further, the solar energy utilization device 1000 may further include a closed container 600.

The liquid condensing unit 100 may be arranged in the closed container 600 to separate out a second closed cavity 601 from the closed container 600. The second closed cavity 601 and the closed cavity of the liquid condensing unit 100 may be connected to or isolated from each other. The second closed cavity may be designed as being filled with vacuum, or with air, water or the same transparent liquid 200 as that in the closed cavity.

In FIG. 3, L may represent light with (latitude) bias. This embodiment shows a case where the directional deviation of light is addressed by means of an asymmetric design of the liquid condensing unit 100.

Referring to FIG. 3, the bottom wall of the light concentrating tank 110 may be designed as the A shaped reflector 111 in the embodiment. The closed container 600 and the second closed cavity 601 shown in the embodiment may be in multiple variations.

In a first variation, the second closed cavity 601 of the closed container 600 may also be provided with the same transparent liquid 200 therein as that in the liquid condensing unit 100. In this situation, the liquid condensing unit 100 may be closed; or a part of the wall of the closed container 600 may be simultaneously served as the wall of the closed container 600 of the liquid condensing unit 100. That is, the closed cavity of the liquid condensing unit may be communicated with the second closed cavity 601; and the light concentrating tank may be the reflecting mirror of the closed container 600.

In a second variation, the liquid condensing unit 100 may be closed, and the second closed cavity 601 of the closed container 600 may be provided with air or vacuum therein. In this situation, the specific gravity of the solar energy utilization device 1000 in the example may be smaller than that of water, so it can float on the water surface and be served as a water-surface photovoltaic system.

In a third variation, the liquid condensing unit 100 may be closed, and the wall of the second closed cavity 301 is provided with an opening 610 for communicating the second closed cavity 601 with the outside world. The second closed cavity 601 may be provided with water connected to the outside. In this case, the solar energy utilization device 1000 in the example may use the heat of solar energy to heat water while generating electricity so as to provide hot water to the outside. The opening 610 in FIG. 3 may be used to connect an external water pipe.

### Example 4:

Referring to FIG. 4, still yet another solar energy utilization device is provided in this Example 4.

In this example, the solar energy utilization device 1000 may include a liquid condensing unit 100 and a light energy utilization unit 300. The liquid condensing unit 100 may include a light concentrating tank 110 and a light receiver 120. Moreover, the liquid condensing unit 100 may further include brims 140 obliquely extended from the light receiver 120 to both sides. The brims 140 may be used to lap with the adjacent liquid condensing unit 100.

Referring to the example shown in FIG. 4, the light energy utilization unit 300 may be directly integrated with the light receiver 120. The light receivers 120 on both sides of the light energy utilization unit 300 may be uplifted to form a concave shape. The light concentrating tank 110 may vary according to the light receiver 120. The brims 140 may be arranged on both sides of the light receiver 120 to form a lap structure so that adjacent solar energy utilization devices 1000 may be lapped together like tiles.

Specifically, the brims 140 may be transparent. This example shows the application of the solar energy utilization device 1000 to (wavy) solar tiles. The brims 140 may be lapped with adjacent solar energy utilization devices 1000 (solar tiles). The liquid condensing unit 100 which takes a folding surface as an example is shown in FIG. 4. For the example, all the folding surfaces may be replaced by curved surfaces, including photovoltaic panels.

The above specific examples are set forth to aid in understanding the present disclosure and are not intended to limit the present disclosure. Variations of those specific embodiments may become apparent to those skilled in the art in light of the teachings herein.

## Claims

1. A solar energy utilization device, comprising:
a light energy utilization unit having a light energy utilization portion capable of receiving, converting and utilizing solar light; and
at least one liquid condensing unit having a closed cavity, a light concentrating tank, and a light receiver for transmitting the solar light into the light concentrating tank, wherein the light receiver and the light concentrating tank form part or all walls of the closed cavity, the closed cavity is filled with a transparent liquid, an inner wall of the light concentrating tank is provided with a reflective surface for reflecting the solar light, the light energy utilization portion is laid above a bottom wall of the light concentrating tank, the transparent liquid is contact with the light receiver, the solar light in the liquid condensing unit transmitted from the transparent liquid to the light receiver forms total reflection so as to concentrate the solar light onto the light energy utilization portion.

2. The solar energy utilization device according to claim 1, wherein the light energy utilization unit is arranged at an outside the light receiver, the light energy utilization portion is attached onto the light receiver so as to concentrate the solar light in the light concentrating tank to the light energy utilization portion.

3. The solar energy utilization device according to claim 1, wherein the light energy utilization portion is arranged in the closed cavity, or the light energy utilization portion forms part wall of the closed cavity.

4. The solar energy utilization device according to any one of claims 1 to 3, wherein a structure is arranged between the light concentrating tank and the light receiver such that the solar light, after being reflected by the reflective surface, is transmitted from the transparent liquid to the light receiver to form the total reflection.

5. The solar energy utilization device according to claim 4, wherein at least part of the reflective surface of the light concentrating tank form an acute angle with the light receiver, the acute angle being less than or equal to 40 degrees.

6. The solar energy utilization device according to claim 4, wherein the transparent liquid fully fills the closed cavity.

7. The solar energy utilization device according to claim 4, wherein the liquid condensing unit is provided with a raised A shaped reflector or a reflective Fresnel lens, and the light energy utilization portion is arranged above the A shaped reflector or the reflective Fresnel lens.

8. The solar energy utilization device according to claim 7, wherein the liquid condensing unit is provided with a gas container made of transparent material, the gas container is arranged on the A shaped reflector or the reflective Fresnel lens, the light energy utilization portion is arranged above the gas container, and the gas container is configured to make at least part of the solar light transmitted from the transparent liquid to form the total reflection so as to concentrate the solar light toward the light energy utilization portion.

9. The solar energy utilization device according to claim 4, wherein the liquid condensing unit is provided with at least a light guide element arranged in the closed cavity for guiding the solar light to the light energy utilization portion by means of reflection or refraction.

10. The solar energy utilization device according to claim 4, further comprising a closed container, wherein the liquid condensing unit is arranged in the closed container to separate a second closed cavity from the closed container, the second closed cavity is filled with a vacuum or with air, water or the same transparent liquid as in the closed cavity.

11. The solar energy utilization device according to claim 10, wherein the second closed cavity is sealed off from the closed cavity of the liquid condensing unit.

12. The solar energy utilization device according to claim 11, wherein a wall of the second closed cavity is provided with an opening to communicate the second closed cavity with outside.

13. The solar energy utilization device according to claim 4, wherein the bottom wall of the light concentrating tank is a reflector in a A shape protrusion.

14. The solar energy utilization device according to claim 4, wherein the liquid condensing unit further comprises a brim obliquely extended from the light receiver to both sides, the brim being configured to lap with an adjacent liquid condensing unit.

15. The solar energy utilization device according to any one of claims 1 to 14, wherein a single side of the light energy utilization unit is provided with the light energy utilization portion, or both sides of the light energy utilization unit are provided with the light energy utilization portion.
